# EUROPEAN PATENT SPECIFICATION

(11) **EP 1 327 912 B1**
(45) Date of publication and mention of the grant of the patent: **03.01.2007**
(21) Application number: 02258143.3
(22) Date of filing: 27.11.2002
(51) Int. Cl.: G03F 7/20

(54) **Lithographic apparatus and device manufacturing method**
Lithographischer Apparat und Verfahren zur Herstellung einer Vorrichtung
Appareil lithographique et méthode de fabrication d'un dispositif

(30) Priority: 30.11.2001 EP 01204626
(43) Date of publication of application: 16.07.2003
(73) Proprietor: ASML Netherlands B.V., 5504 DR Veldhoven (NL)
(72) Inventor: Jacobs, Hernes, 5627 CJ Eindhoven (NL); Vosters, Piet, 5531 EH Bladel (NL); Hol, Sven Antoln Johan, 5623 AW Eindhoven (NL); van der Schoot, Harmen Klass, 5262 RK Vught (NL); van Diesen, Robert Johannes Petrus, 5688 BA Oirscot (NL); Callan, David William, Norwalk CT 06851 (US)
(74) Representative: Leeming, John Gerard

(56) References cited:
- EP-A- 1 148 389
- DE-A- 10 036 217
- US-A- 4 993 696
- PATENT ABSTRACTS OF JAPAN vol. 017, no. 625 (E-1461), 18 November 1993 (1993-11-18) & JP 05 198490 A (FUJITSU LTD), 6 August 1993 (1993-08-06)
- PATENT ABSTRACTS OF JAPAN vol. 018, no. 684 (E-1650), 22 December 1994 (1994-12-22) & JP 06 275486 A (TOPCON CORP), 30 September 1994 (1994-09-30)

## Description

The present invention relates to conduits for providing utilities such as power, water, control signals and gases through cables, hoses or pipes to a movable component in a vacuum chamber. More particularly, the invention relates to the incorporation of such devices in a lithographic projection apparatus comprising:
a radiation system for providing a projection beam of radiation;
a first object table for supporting patterning means, the patterning means serving to pattern the projection beam according to a desired pattern;
a second object table for holding a substrate;
a vacuum chamber provided with a first gas evacuating means for generating a vacuum beam path for the projection beam;
a projection system for projecting the patterned beam onto a target portion of the substrate; and
a conduit for providing utilities to a component moveable in at least one degree of freedom in said vacuum chamber.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:
A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the first object table will generally be a mask table, which ensures that the mask can be held at a desired position in the incoming radiation beam, and that it can be moved relative to the beam if so desired.

A programmable mirror array. One example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-adressable surface. An alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described hereabove, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096. In the case of a programmable mirror array, the said support structure may be embodied as a frame or table, for example, which may be fixed or movable as required.
- A programmable LCD array. An example of such a construction is given in United States Patent US 5,229,872. As above, the first object table in this case may be embodied as a frame or table, for example, which may be fixed or movable as required.
For purposes of simplicity, the rest of this text may, at certain locations, specifically direct itself to examples involving a mask and mask table; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (e.g. comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper. In an alternative apparatus - commonly referred to as a step-and-scan apparatus - each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Twin stage lithographic apparatus are described, for example, in US 5,969,441 and WO 98/40791.

In a lithographic apparatus, the size of features that can be imaged onto the substrate is limited by the wavelength of the projection radiation. To produce integrated circuits with a higher density of devices and hence higher operating speeds, it is desirable to be able to image smaller features. Whilst most current lithographic projection apparatus employ ultraviolet light generated by mercury lamps or excimer lasers, it has been proposed to use shorter wavelength radiation of around 13nm. Such radiation is termed extreme ultraviolet (EUV) or soft x-ray, and possible sources include laser produced plasma sources, discharge plasma sources or synchrotron radiation from electron storage rings. An outline design of a lithographic projection apparatus using synchrotron radiation is described in "Synchrotron radiation sources and condensers for projection x-ray lithography", JB Murphy et al, Applied Optics Vol. 32 No. 24 pp 6920-6929 (1993).

Other proposed radiation types include electron beams and ion beams. Further information with regard to the use of electron beams in lithography can be gleaned, for example, from US 5,079,112 and US 5,260,151, as well as from EP-A-0 965 888. These types of beam share with EUV the requirement that the beam path, including the mask, substrate and optical components, be kept in a high vacuum. This is to prevent absorption and/or scattering of the beam, whereby a total pressure of less than about 10⁻⁶ millibar is typically necessary for such charged particle beams. Otherwise, for apparatus using EUV radiation, the total vacuum pressure need only be between 10⁻³ and 10⁻⁵ millibar. Optical elements for EUV radiation can be spoiled, by the deposition of carbon layers on their surface, which imposes the additional requirement that hydrocarbon partial pressures should generally be kept as low as possible, for example below 10⁻⁸ or 10⁻⁹ millibar.

Working in a high vacuum imposes quite onerous conditions on the components that must be put into the vacuum. For components inside the vacuum chamber, materials should be used that minimize or eliminate contaminant and total out-gassing, i.e. both out-gassing from the materials themselves and from gases adsorbed on their surfaces. It has been found that for the desired degree of movement required by the object holders, conduits can be made of plastics materials so that they are flexible enough. However, these types of materials often are deleterious to the vacuum in the vacuum chamber because out-gassing of contaminants as described above will occur. There are plastics better suited for vacuum applications (e.g. teflon), but the large number of cables and lines which are required to be led through the vacuum present a large surface area to out-gassing of contaminants. It will be difficult to get a partially hydrocarbon pressure below 10⁻⁸ or 10⁻⁹ millibar, for example, when plastic conduits are used. Furthermore, the risk of leaks from conduits makes their use impractical. It would be very desirable to be able to reduce the use of conduits. However, conventional designs of substrate, mask and transfer stages are very complicated and employ large numbers of sensors and drive arrangements, which all need a large numbers of conduits for conveying water and gases and for protecting electric wiring.

To circumvent this problem it has been proposed in US 4,993,696 to use metal pipes made of stainless material for the supply and exhaustion of an operating fluid or gas in a vacuum ambience. Two adjacent pipes may then be coupled with each other by a joint, which is arranged to allow swingable movement of one of the pipes relative to the other. The (metal pipes) will not suffer from out-gassing, as the nylon conduits will do. A disadvantage of the joints is that it is very difficult to design joints that are totally closed for fluids or gases in a vacuum environment. Therefor there may be leakage of gases through the joint to the vacuum environment what will contaminate the vacuum environment

Another solution has been proposed by European Patent Application 1 052 549. In this publication conduits are fed through hollow pipes that are rigidly connected to a movable object table and which pipes are used to transfer movements from outside a vacuum chamber to said table. The pipes are hollow and the pressure within the pipes is equal to the pressure outside the vacuum chamber. Between the wall of the vacuum chamber and the pipes differentially pumped seals are used to prevent the leakage of air to the vacuum chamber and at the same time allowing for movement of the object table.

Patent Abstracts of Japan relating to JP-A-05-198490 discloses a charged particle beam exposure system in which bellows provide flow paths for refrigerant to a Y stage and between the Y stages and an X stage.

According to the invention there is provided a lithographic projection apparatus comprising:
a radiation system for providing a projection beam of radiation;
a first object table for supporting patterning means, the patterning means serving to pattern the projection beam according to a desired pattern;
a second object table for holding a substrate;
a vacuum chamber provided with a first gas evacuating means for generating a vacuum beam path for the projection beam;
a projection system for projecting the patterned beam onto a target portion of the substrate; and
a conduit for providing utilities to a component moveable in at least one degree of freedom in said vacuum chamber, the conduit comprising a flexible metal bellow, characterized in that
said conduit further comprises a flexible plate for carrying said flexible metal bellow in a first direction parallel to gravity and guiding said bellow in a second and third direction perpendicular to the first direction.

The term conduit refers to the cables and tubes that are used to transport the utilities to the moveable component. More specifically the term conduit refers to such items as power cords, signal carriers, gas tubes (e.g. for supplying gas to a gas bearing in the table), coolant tubes, etc. Moveable components inside the vacuum chamber including the mask table and/or the substrate table and/or associated motors and/or sensors may be connected to a frame outside the vacuum chamber in this manner.

The flexible metal bellow will be substantially airtight and at the same time flexible enough to allow for movement of the component. The metal surface of the flexible metal bellow will not suffer from large out-gassing and at the same time be easily cleanable so that no problems will occur with any pollution adsorbed on the surface of the flexible metal bellow. Further, the conduit with the flexible metal bellow is very light weight in comparison with the pipes with movable joints suggested in United States Patent 4,993,696 and the differential pumped seals suggested in European Patent Application 1 052 549. The flexible metal bellow also allows easily for some more degrees of freedom than the solutions proposed in the mentioned prior art.

The conduit may be provided with a fixed bend in a part of the conduit for restricting the amount of bending in the rest of the conduit during movement of the component. If the flexible metal bellow bends a lot of time during usage the flexible metal bellow will lose its strength and may get leak. This problem is alleviated by limiting the bending during usage of the metal bellow to a minimal radius. This minimal radius requirement for the bellow may require a lot of space in the machine for the bellow. By having a fixed bend in a particular part of the conduit the bending of the rest of the conduit is limited during usage while the minimal radius requirement is loosened. The large degree of bending in said particular part is fixed so hardly any wear of the metal bellow in that part will occur.

The conduit may be connected to a damping means for damping vibrations in the conduit. Vibrations in the conduit may have an influence on the position of the movable component which influence should be avoided as much as possible. According to a second aspect of the present invention there is provided a device manufacturing method using a lithographic apparatus comprising the steps of:
providing a substrate that is at least partially covered by a layer of radiation-sensitive material;
providing a vacuum to a vacuum chamber;
projecting a projection beam of radiation using a radiation system through said vacuum chamber;
using patterning means to endow the projection beam with a pattern in its cross-section;
projecting the patterned projection beam of radiation onto a target portion of the layer of radiation-sensitive material,
providing utilities through a conduit to at least one component moveable in at least a first direction in said vacuum chamber through a flexible metal bellow; characterized by the steps of carrying said metal bellow in a first direction parallel to gravity with a flexible metal plate and guiding said bellow in second and third directions perpendicular to said first direction, with said flexible metal plate.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

The present invention and its attendant advantages will be described below with reference to exemplary embodiments and the accompanying schematic drawings, in which:
Fig. 1 depicts a lithographic projection apparatus according to the invention;
Fig. 2 is a schematic plan view showing a conduit employing a flexible metal bellow according to the invention;
Fig. 3 is a view in perspective on the conduit shown in figure 2;
Fig. 4 is a cross-sectional view on the flexible metal bellow according to the invention and for usage in the conduit in figure 2 and 3, and
Fig. 5 is a schematic view on a conduit according to a second embodiment of the invention.

### Embodiment 1

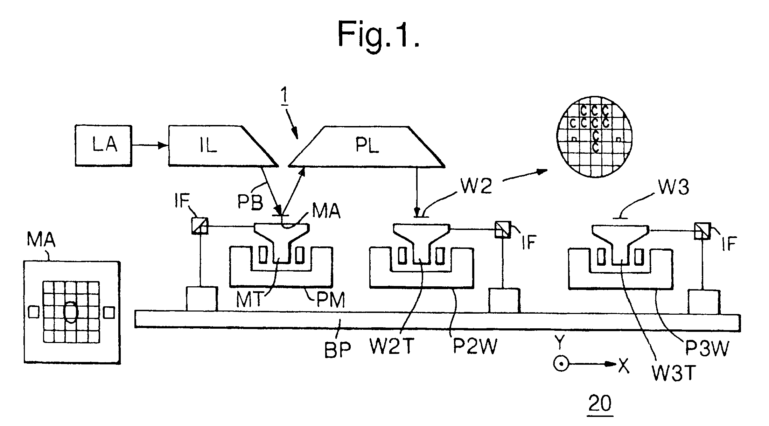

Figure 1 schematically depicts a lithographic projection apparatus 1 according to the invention. The apparatus comprises:
- a radiation system LA, IL for supplying a projection beam PB of radiation (e.g. UV or EUV radiation, electrons or ions);
- a first object table (mask table) MT provided with a first object (mask) holder for holding a mask MA (e.g. a reticle), and connected to first positioning means PM for accurately positioning the mask with respect to item PL;
- a second object table (substrate table) W2T provided with a second object (substrate) holder for holding a substrate W2 (e.g. a resist-coated silicon wafer), and connected to second positioning means P2W for accurately positioning the substrate with respect to item PL;
- a third object table (substrate table) W3T provided with a third object (substrate) holder for holding a substrate W3 (e.g. a resist-coated silicon wafer), and connected to third positioning means P3W for accurately positioning the substrate with respect to item PL; and
- a projection system ("lens") PL (e.g. a refractive or catadioptric system, a mirror group or an array of field deflectors) for imaging an irradiated portion of the mask MA onto a target portion of the substrate W.

The radiation system comprises a source LA which produces a beam of radiation (e.g. an undulator or wiggler provided around the path of an electron beam in a storage ring or synchrotron, a plasma source, an electron or ion beam source, a mercury lamp or a laser). This beam is caused to traverse various optical components included in illumination system IL so that the resultant beam PB has a desired shape and intensity distribution in its cross-section.

The beam PB subsequently impinges upon the mask MA that is held in a mask holder on a mask table MT. Having been selectively reflected (or transmitted) by the mask MA, the beam PB passes through the "lens" PL, which focuses the beam PB onto a target portion of the substrate W2, W3. With the aid of the positioning means P2W, P3W and interferometric displacement measuring means IF, the substrate table W2T, W3T can be moved accurately, e.g. so as to position different target portions in the path of the beam PB. Similarly, the positioning means PM and interferometric displacement measuring means IF can be used to accurately position the mask MA with respect to the path of the beam PB, e.g. after mechanical retrieval of the mask MA from a mask library or during a scanning motion. In the prior art, movement of the object tables MT, W2T is generally realized with the aid of a long-stroke module (course positioning) and a short-stroke module (fine positioning), which are not explicitly depicted in Figure 1. The depicted apparatus can be used in two different modes:
- In step mode, the mask table MT is kept essentially stationary, and an entire mask image is projected in one go (i.e. a single "flash") onto a target portion The substrate table W2T, is then shifted in the X and/or Y directions so that a different target portion can be irradiated by the beam PB;
- In scan mode, essentially the same scenario applies, except that a given target portion is not exposed in a single "flash", Instead, the mask table MT is movable in a given direction (the so-called "scan direction", e.g. the Y direction) with a speed v, so that the projection beam PB is caused to scan over a mask image; concurrently, the substrate table W2T, is simultaneously moved in the same or opposite direction at a speed V = Mv, in which M is the magnification of the lens PL (e.g., M = 1/4 or 1/5). In this manner, a relatively large target portion can be exposed, without having to compromise on resolution.

In a lithographic projection apparatus according to the present invention, at least one of first and second object tables are provided in a vacuum chamber 20. The vacuum inside the vacuum chamber 20 is created with a vacuum evacuating means, for example a pump.

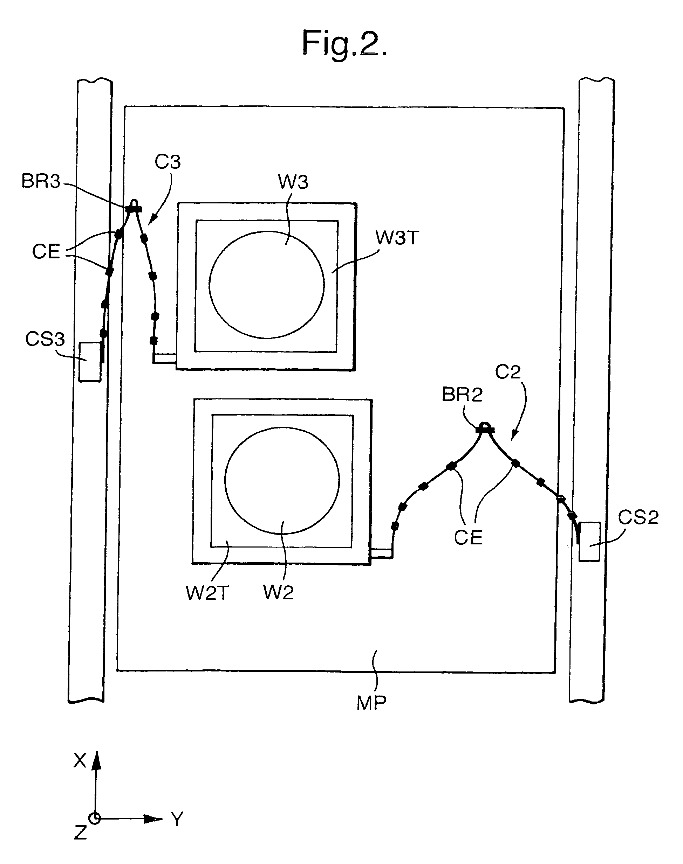

Fig. 2 is a schematic plan view showing a conduit according to the invention. Two conduits C2 and C3 connect the substrate table W2T respectively W3T to their respective cable shuttle CS2 and CS3. The cable shuttles CS2 and CS3 will follow their respective table in the X-direction by having a detector that detects the position of the table with respect to the cable shuttle and which detector causes the cable shuttle to adjusts its position if the table moves in the X-direction away from the cable shuttle, so that the shuttle follows the substrate table. In the Y-direction, the conduits C2 and C3 will allow for movement of the substrate tables W2T and W3T. The substrate table W3T and W2T are positioned with the aid of a planar motor comprising a magnet array in the magnet plate MP and coils in the substrate table W2T and W3T for movement and levitation of the substrate tables.

As depicted in figure 2, both tables have a single conduit, however it is considered advantageous to have double conduits, because it makes a lower design possible. For this reason, additional conduits can be mounted on the inside of the depicted conduits. Both conduits may be coupled to each other at the fixed bend so that they will be kept away from each other during movement of the substrate table.

Both substrate tables W3T and W2T may exchange position by moving in the Y-direction to their respective cable shuttle and subsequently move in the X-direction passing each other. During an exchange of tables, the cable shuttles will also move in the X-direction.

The conduit may be provided with a fixed bend provided by BR2 and BR3 in a particular part of the conduit C2 or C3 for restricting the amount of bending in the rest of the conduit C2 or C3 during movement of the component W2T or W3T. If the flexible metal bellow would bend often during usage the flexible metal bellow may loose its strength and may get leak. This problem is alleviated by limiting the bending during usage of the metal bellow to a minimal radius. The minimal radius requirement for the bellow may cost a lot of space in the machine for the bellow. By having a fixed bend, BR2 or BR3 in a particular part of the conduit C2 or C3 the lending of the rest of the conduit is limited during usage while the minimal radius requirement is loosened. The large degree of bending in said fixed bend BR2 or BR3 is fixed so hardly any wear of the metal bellow in that part will occur. This may also help preventing wear and at the same time loosening the space requirements for conduits of non-metal material used in a non-vacuum lithographic projection apparatus. The conduit may then be made of plastic or rubber.

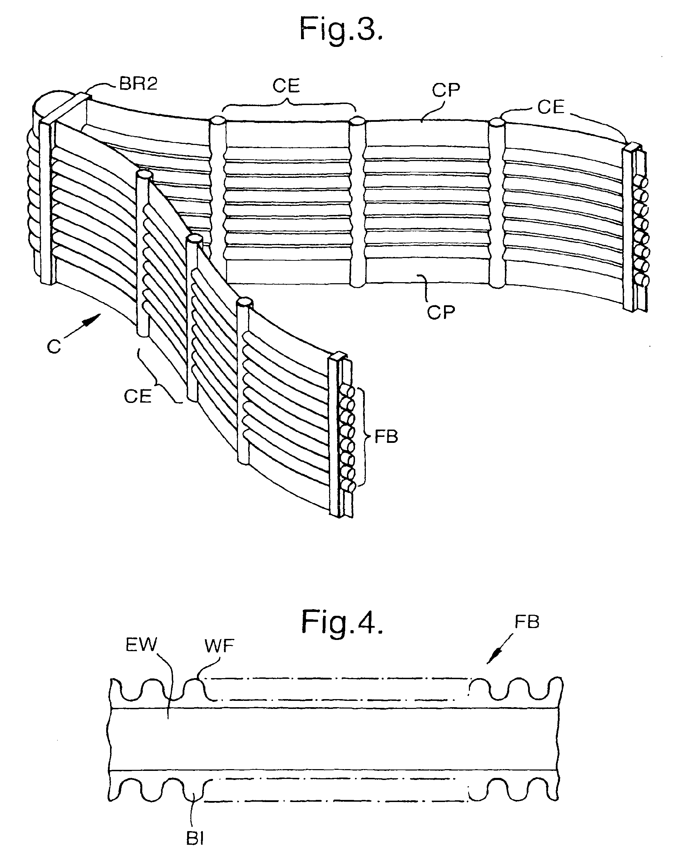

Vibrations in the conduit may be damped by providing aluminum material to the conduits C2 or C3. The aluminum will work as a damper because the magnet field of the magnet plate MP will cause an eddy current within the aluminum which damps the vibrations of the conduit C2 or C3 producing heat. The fixed bends BR2 or BR3 may be provided with aluminum for this purpose. The connecting elements CE that are used to connect the flexible metal bellows FB (see figure 3) with the conduit plates CP may also be made from aluminum for the same purpose. The connecting elements CE increase the stiffness in the Z-direction of the conduit C so that sacking of the flexible metal bellows FB is avoided.

The conduit plates CP are used to supply the conduit with stiffness in the Z-direction while at the same time supplying some flexibility in the X-and Y-direction. The flexibility over the length of the conduit plates CP may be varied to adjust the flexibility locally of the conduit C. The flexibility of the conduit plate CP in a particular part of the conduit C will have its influence on the extent of bending in the flexible bellows FB at said particular part in the X- and Y-direction. In general, a flexible bellow FB will have its maximal bending near the position where it is connected to the fixed world i.e. for the conduit C2 near the substrate table W2T or the cable shuttle CS2, By adding extra stiffness to the conduit plate CP near those positions the bending can be better divided over the total length of the flexible bellow FB so that the wear of the flexible bellow is better divided over said length and the total lifetime will be longer. Adding extra stiffness to the conduit plate CP can be done by varying the outer dimensions of the plate or by weakening the conduit plate CP by making holes in it. Experiments can be executed to determine the position along the conduit C where the wear of the flexible bellows FB is maximal and by adding stiffness to the conduit plate CP at those positions the wear can be better divided.

By having the connecting elements CE made of a metal having a high thermal conductivity, like e.g. aluminum, such connecting element can act as a heat sink. The heat generated by copper wires, which are also connected to the connecting elements and which serve as a power cord or a signal wire to the substrate table, may then be easily transferred to the cooling medium (e.g. water) flowing in a metal bellows. By using several connecting elements CE along the conduit a regular heat distribution pattern is created with smaller temperature differences along the wire, allowing for a better temperature control within the vacuum chamber.

Fig. 4 is a cross-sectional view on the flexible metal bellows FB according to the invention. The bellow may be provided with electric wiring or a water tube EW in its interior BI. The bellow itself is made from metal in a waveform WF giving flexibility to the bellow.

One could feed forward compensate for the influence of the mass of the conduits (C1 or C2) on the movements of the substrate tables. This can be done either by calibration of the force influence or by making an algorithm calculating this force influence. Alternatively, force sensors can be used between the substrate table and the conduit, which measure the force exerted by the substrate table on the conduit and feed back compensate that force by adjusting the force exerted by the positioning means, Further information with regard to such a feed bade system can be gleaned from European Patent Application EP 1 018 669.

### Embodiment 2

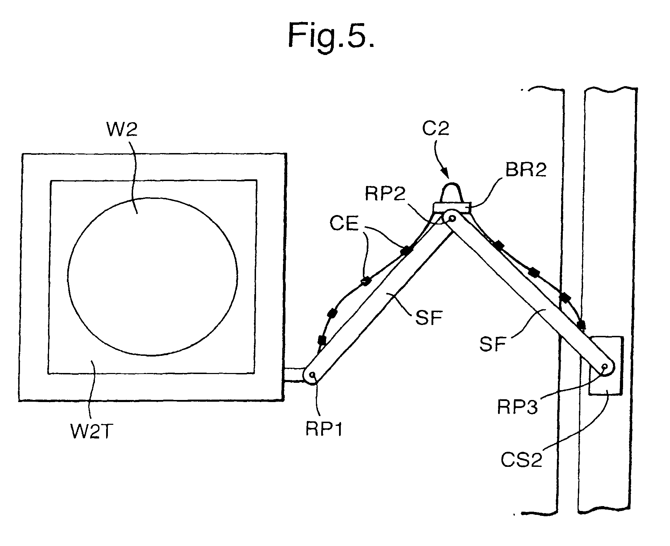

Figure 5 shows a second embodiment of the invention. In this figure, the substrate table W2T and the conduit C2 of figure 2 is provided with a sub-frame SF. The sub-frame SF is connected to the substrate table W2T at rotation point RP1, with the fixed bend BR2 at rotation point RP2 and with the cable shuttle CS2 at rotation point RP3. The sub-frame SF comprises two legs, which rotate around RP2 with each other. The sub-frame SF positions the fixed bend during movement in a stiff way in a particular position so that vibrations will be decreased.

The invention is described above in relation to preferred embodiments; however, it will be appreciated that the invention which is defined by the claims is not limited by the above description. In particular, the invention has been described above in relation to the wafer stage of a lithographic apparatus that is accommodated in a vacuum chamber. However, it will readily be appreciated that the present invention is equally applicable to mask tables or to any movable mirrors in the apparatus.

## Claims

1. A lithographic projection apparatus comprising:
a radiation system (IL) for providing a projection beam (PB) of radiation;
a first object table (MT) for supporting patterning means (MA), the patterning means serving to pattern the projection beam according to a desired pattern;
a second object table (WT) for holding a substrate (W);
a vacuum chamber (20) provided with a first gas evacuating means for generating a vacuum beam path for the projection beam;
a projection system (PL) for projecting the patterned beam onto a target portion of the substrate; and
a conduit (C2, C3) for providing utilities to a component (W2T, W3T) moveable in at least one degree of freedom in said vacuum chamber, the conduit comprising a flexible metal bellow (FB), **characterized in that**
said conduit further comprises a flexible plate (CP) arranged to carry said flexible metal bellow in a first direction parallel to gravity and arranged to guide said bellow in a second and third direction perpendicular to the first direction.

2. A lithographic projection apparatus according to claim 1, wherein said conduit comprises a connecting element (CE) for connecting the flexible plate with the flexible metal bellow.

3. A lithographic projection apparatus according to claim 2, wherein said connecting element (CE) is made of a metal having a high thermal conductivity.

4. A lithographic projection apparatus according to claim 1, 2 or 3, wherein the flexibility of the flexible plate (CP) in said second an third direction is varied over its total length.

5. A lithographic projection apparatus according to any one of the preceding claims, wherein said conduit comprises a fixed bend (BR2, BR3) in a part of the conduit for restricting the space required for the conduit.

6. A lithographic projection apparatus according to any of the preceeding claims
wherein said conduit is connected to a damping means for damping vibrations in said conduit.

7. A lithographic projection apparatus according to claim 6 wherein said damping means is an eddy current damper that damps under the influence of a magnet field provided by a magnet plate.

8. A lithographic projection apparatus according any of the preceding claims wherein said conduit is provided with a sub-frame (SF) for preventing vibrations in the conduit.

9. A device manufacturing method using a lithographic apparatus comprising the steps of:
providing a substrate (W) that is at least partially covered by a layer of radiation-sensitive material;
providing a vacuum to a vacuum chamber (20);
projecting a projection beam (PB) of radiation using a radiation system (IL) through said vacuum chamber;
using patterning means (MA) to endow the projection beam with a pattern in its cross-section;
projecting the patterned projection beam of radiation onto a target portion of the layer of radiation-sensitive material,
providing utilities through a conduit to at least one component moveable in at least a first direction in said vacuum chamber through a flexible metal bello (FB); **characterized by** the steps of
carrying said metal bellow in a first direction parallel to gravity with a flexible plate (CP) and guiding said bellow in second and third directions perpendicular to said H first direction with said flexible metal plate.

10. A method according to claim 9 wherein said method comprises the step of damping vibrations of the conduit with a damping means.

## Patentansprüche

1. Ein lithografischer Projektionsapparat, aufweisend:
ein Bestrahlungssystem (IL) zur Zufuhr eines Projektionsstrahls (PB) einer Strahlung;
einen ersten Objekttisch (MT) zum Tragen von Musterungsmitteln (MA), wobei die Musterungsmittel dazu dienen, den Projektionsstrahl gemäß einem gewünschten Muster zu mustern;
einen zweiten Objekttisch (WT) zum Halten eines Substrats (W);
eine Vakuumkammer (20) mit ersten Gasevakuierungsmitteln zur Bereitstellung eines Vakuum-Strahlpfades für den Projektionsstrahl.
ein Projektionssystem (PL) zum Projizieren des gemusterten Strahls auf einen Zielabschnitt auf dem Substrat; und
eine Leitung (C2, C3) zur Bereitstellung von Hilfsmitteln an ein Bauteil (W2T, W3T), das mit wenigstens einem Freiheitsgrad in der Vakuumkammer beweglich ist, wobei die Leitung einen flexiblen Metall-Faltenbalg (FB) aufweist,
**dadurch gekennzeichnet, dass**
die Leitung weiterhin eine flexible Platte (CP) aufweist, welche den flexiblen Metall-Faltenbalg in einer ersten Richtung parallel zur Schwerkraft zu tragen vermag und welche den Faltenbalg in einer zweiten und dritten Richtung senkrecht zur ersten Richtung zu führen vermag.

2. Ein litografischer Projektionsapparat nach Anspruch 1, wobei die Leitung ein Verbindungselement (CE) zur Verbindung der flexiblen Platte mit dem flexiblen Metall-Faltenbalg aufweist.

3. Ein litografischer Projektionsapparat nach Anspruch 2, wobei das Verbindungselement (CE) aus einem Metall mit hoher thermischer Leitfähigkeit ist.

4. Ein litografischer Projektionsapparat nach Anspruch 1, 2 oder 3, wobei die Flexibilität der flexiblen Platte (CP) in der zweiten und dritten Richtung sich über ihre Gesamtlänge hinweg ändert.

5. Ein litografischer Projektionsapparat nach einem der vorhergehenden Ansprüche, wobei die Leitung eine flexible Biegestelle (BR2, BR3) in einem Teil der Leitung aufweist, um den für die Leitung notwendigen Raum zu begrenzen.

6. Ein litografischer Projektionsapparat nach einem der vorhergehenden Ansprüche, wobei die Leitung mit Dämpfungsmitteln zum Dämpfen von Vibrationen in der Leitung verbunden ist.

7. Ein litografischer Projektionsapparat nach Anspruch 6, wobei die Dämpfungsmittel durch eine Wirbelstrombremse gebildet sind, die unter dem Einfluss eines Magnetfelds dämpft, das von einer Magnetplatte bereitgestellt wird.

8. Ein litografischer Projektionsapparat nach einem der vorhergehenden Ansprüche, wobei die Leitung mit einem Unterrahmen (SF) zur Verhinderung von Vibrationen in der Leitung versehen ist.

9. Ein Verfahren zur Herstellung einer Vorrichtung unter Verwendung einer litografischen Vorrichtung, aufweisend die Schritte von:
Bereitstellen eines Substrats (W), welches zumindest teilweise mit einer Schicht eines strahlungsempfindlichen Materials bedeckt ist;
Anlegen eines Vakuums an eine Vakuumkammer (20);
Projizieren eines Projektionsstrahls (PB) einer Strahlung unter Verwendung eines Bestrahlungssystems (IL) durch die Vakuumkammer hindurch;
Verwenden von Musterungsmitteln (MA), um den Strahl in seinem Querschnitt mit einem Muster zu versehen;
Projizieren des gemusterten Strahls der Strahlung auf einen Zielabschnitt der Schicht aus strahlungsempfindlichem Material;
Bereitstellen von Hilfsmitteln durch eine Leitung an wenigstens ein Bauteil, das in der Vakuumkammer in wenigstens einer Richtung beweglich ist, durch einen flexiblen Metall-Faltenbalg (FB),
**gekennzeichnet durch** die Schritte von
Tragen des Metall-Faltenbalgs in einer ersten Richtung parallel zur Schwerkraft mittels einer flexiblen Platte (CP) und Führen des Faltenbalgs in zweiten und dritten Richtungen senkrecht zu der ersten Richtung mittels der flexiblen Metallplatte.

10. Ein Verfahren nach Anspruch 9, wobei das Verfahren den Schritt des Dämpfens von Vibrationen in der Leitung mit Dämpfungsmitteln aufweist.

## Revendications

1. Appareil de projection lithographique comportant :
un système de rayonnement (IL) pour fournir un faisceau de projection (PB) de rayonnement ;
une première table d'objet (MT) pour supporter des moyens de mise en forme (Ma), les moyens de mise en forme servant à mettre en forme le faisceau de projection conformément à un motif voulu ;
une seconde table d'objet (WT) pour supporter un substrat (W) ;
une chambre de vide (20) munie de premiers moyens d'évacuation de gaz pour produire un chemin de faisceau sous vide pour le faisceau de projection ;
un système de projection (PL) pour projeter le faisceau mis en forme sur une partie cible du substrat ; et
un conduit (C2, C3) pour assurer des services à un composant (W2T, W3T) mobile dans au moins un degré de liberté dans ladite chambre de vide, le conduit comportant un soufflet métallique flexible (FB), **caractérisé en ce que**
ledit conduit comporte de plus une plaque flexible(CP) agencée pour supporter ledit soufflet métallique flexible dans une première direction parallèle à la gravité et agencée pour guider ledit soufflet dans une deuxième direction et une troisième direction perpendiculaires à la première direction.

2. Appareil de projection lithographique selon la revendication 1, dans lequel ledit conduit comporte un élément de raccordement (CE) pour raccorder la plaque flexible au soufflet métallique flexible.

3. Appareil de projection lithographique selon la revendication 2, dans lequel ledit élément de raccordement (CE) est constitué d'un métal ayant une grande conductivité thermique.

4. Appareil de projection lithographique selon la revendication 1, 2 ou 3, dans lequel la flexibilité de la plaque flexible, (CP) dans ladite deuxième et troisième direction est variée sur sa longueur totale.

5. Appareil de projection lithographique selon l'une quelconque des revendications précédentes, dans lequel ledit conduit comporte un coude fixe (BR2, BR3) dans une partie de conduit pour limiter l'espace requis pour le conduit.

6. Appareil de projection lithographique selon l'une quelconque des revendications précédentes, dans lequel ledit conduit est raccordé à des moyens d'amortissement pour amortir des vibrations dans ledit conduit.

7. Appareil de projection lithographique selon la revendication 6, dans lequel lesdits moyens d'amortissement sont un amortisseur à courant de Foucault qui amortit sous l'influence d'un champ magnétique fourni par une plaque d'aimant.

8. Appareil de projection lithographique selon l'une quelconque des revendications précédentes, dans lequel ledit conduit est muni d'un sous-châssis (SF) pour empêcher des vibrations dans le conduit.

9. Procédé de fabrication de dispositif utilisant un appareil lithographique comportant les étapes consistant à :
fournir un substrat (W) qui est au moins partiellement recouvert d'une couche de matériau sensible à un rayonnement ;
mettre sous vide une chambre de vide (20) ;
projeter un faisceau de projection (PB) d'un rayonnement en utilisant un système de rayonnement (IL) à travers ladite chambre de vide ;
utiliser des moyens de mise en forme (MA) pour doter le faisceau de projection d'un motif dans sa section transversale ;
projeter le faisceau de projection de rayonnement mis en forme sur une partie cible de la couche de matériau sensible au rayonnement,
assurer des services par un conduit pour au moins un composant mobile dans au moins une première direction dans ladite chambre de vide par l'intermédiaire d'un soufflet métallique flexible (FB) ; **caractérisé par** les étapes suivantes :
supporter ledit soufflet métallique dans une première direction parallèle à la gravité à l'aide d'une plaque flexible (CP) et guider ledit soufflet dans une deuxième direction et une troisième direction perpendiculaires à ladite première direction avec ladite plaque métallique flexible.

10. Procédé selon la revendication 9, dans lequel ledit procédé comporte l'étape d'amortir des vibrations du conduit à l'aide de moyens d'amortissement.
